# EUROPÄISCHE PATENTSCHRIFT

(11) **EP 2 161 839 B1**
(45) Veröffentlichungstag und Bekanntmachung des Hinweises auf die Patenterteilung: **21.06.2017**
(21) Anmeldenummer: 09009554.8
(22) Anmeldetag: 23.07.2009
(51) Int. Cl.: H03K 19/003, H03K 19/173, G06F 11/20

(54) **Flugfunkgerät und Verfahren mit dynamisch rekonfigurierbarer Redundanz**
Aviation radio device and method with dynamically reconfigurable redundancy
Appareil radio aérien et procédé ayant une redondance reconfigurable dynamique

(30) Priorität: 04.09.2008 DE 102008045717
(43) Veröffentlichungstag der Anmeldung: 10.03.2010
(73) Patentinhaber: Rohde & Schwarz GmbH & Co. KG, 81671 München (DE)
(72) Erfinder: Foag, Jürgen, Dr., 81375 München (DE)
(74) Vertreter: Körfer, Thomas

(56) Entgegenhaltungen:
- US-A1- 2003 162 503
- US-A1- 2006 236 209
- US-A1- 2007 057 693

## Beschreibung

Die Erfindung betrifft ein dynamisch rekonfigurierbares Flugfunkgerät und ein Verfahren zur dynamischen Rekonfiguration.

FPGA-basierte Geräte weisen üblicherweise eine geringe Strahlungstoleranz auf. Durch auftreffende Strahlung werden die Speicherzellen des FPGA umgeladen, was zu Änderungen der Funktionalität des FPGA führt. Üblicherweise werden Fehler an FPGAs durch Watchdog-Schaltungen überwacht. Eine Möglichkeit ist z.B. die Überprüfung, ob das FPGA ein zyklisches Taktsignal ausgibt. Eine Überprüfung der genauen Funktionalität des FPGA ist so jedoch nicht möglich. Üblicherweise kann bei Feststellung eines Fehlers in FPGA-basierten Schaltungen keine Korrektur dieses Fehlers im Betrieb durchgeführt werden. Ein Abschalten des Systems und eine Rekonfiguration des FPGA sind notwendig, um die Funktionalität wiederherzustellen.

Üblicherweise werden bei der Erstellung von FPGA-basierten Systemen FPGAs mit weit größerer Kapazität eingesetzt, als für die geplante Kernfunktionalität der Systeme notwendig ist. Dies geschieht, um spätere Korrekturen, Änderungen und Funktionserweiterungen ohne Ersatz des FPGA durchführen zu können. Diese überschüssige Kapazität liegt jedoch brach, sofern eine solche Korrektur oder Änderung ausbleibt.

Darüber hinaus sind FPGA-Systeme bekannt, welche bei Detektion eines Fehlers automatisch eine Rekonfiguration des betroffenen Bereichs durchführen. So zeigt die US 7,310,759 B1 ein FPGA-System, welches das Auftreten von Fehlern durch redundante Vorhaltung von Kopien identischer Funktionsblöcke detektiert, und automatisch eine Rekonfiguration fehlerhafter Konfigurationsbereiche des FPGAs durchführt. Weiterhin erfolgt die Lokalisierung fehlerhafter Konfigurationsbereiche des FPGAs durch einen ressourcenaufwendig kontinuierlich durchgeführten Konfigurationsreadback. Hierzu wird ein eigener Prozessor, welcher Energie verbraucht, benötigt. Nachteile dieses Systems sind seine noch immer verbesserungsfähige Zuverlässigkeit sein hoher Energieverbrauch und sein aufwendiger Aufbau.

Das Dokument US 2007/0057693 A1 zeigt eine rekonfigurierbare Schaltung mit redundanten rekonfigurierbaren Schaltungselementen. Dabei ist die Verteilung der Schaltungselemente von vornherein festgelegt. Die Konfigurierbarkeit besteht darin, dass im Fall des Auftretens eines Fehlers einzelne Schaltungselemente aus der Schaltung entfernt und durch die redundant vorkommendenden Schaltungselemente ersetzt werden.

Das Dokument US 2006/0236209 A1 zeigt eine dynamisch rekonfigurierbare Schaltung. Wird dabei ein defekter Funktionsblock in einem rekonfigurierbaren Schaltungselement entdeckt, wird dieser Funktionsblock rekonfiguriert und damit erneut in einen funktionsfähigen Zustand versetzt.

Der Erfindung liegt die Aufgabe zu Grunde, ein Flugfunkgerät und ein Verfahren zur dynamischen Rekonfiguration eines Flugfunkgeräts zu schaffen, welche einen sehr zuverlässigen Betrieb ermöglichen.

Die Aufgabe wird erfindungsgemäß für das Flugfunkgerät und das zugehörige Verfahren durch die Merkmale der unabhängigen Ansprüche gelöst. Vorteilhafte Weiterbildungen sind Gegenstand der hierauf rückbezogenen Unteransprüche.

Das erfindungsgemäße Flugfunkgerät verfügt über ein dynamisch rekonfigurierbares Schaltungselement mit vorgegebener Kapazität. Das Flugfunkgerät weist mehrere Funktionszustände mit jeweils mehreren Funktionsblöcken auf. Das dynamisch rekonfigurierbare Schaltungselement realisiert zumindest einen Funktionsblock. Jeder von dem dynamisch rekonfigurierbaren Schaltungselement realisierte Funktionsblock nutzt eine bestimmte Kapazität des dynamisch rekonfigurierbaren Schaltungselements. Die Differenz der vorgegebenen Kapazität des dynamisch rekonfigurierbaren Schaltungselements und der maximal benötigten Kapazität der Funktionsblöcke der Funktionszustände bildet eine freie Kapazität. Die freie Kapazität hält redundante Funktionsblöcke vor. Die redundanten Funktionsblöcke sind dabei dynamisch rekonfigurierbar. Die Funktionsblöcke der Funktionszustände des Flugfunkgeräts sind dabei in Abhängigkeit von bestimmten Anwendungsfällen nach ihrer Relevanz für eine Systemsicherheit bewertet. Die freie Kapazität hält dabei die redundanten Funktionsblöcke in Abhängigkeit von der Relevanz für die bestimmten Anwendungsfälle redundant vor.

So wird bei verfügbarer freier Kapazität die Zuverlässigkeit des Flugfunkgeräts deutlich erhöht, ohne die Möglichkeit zukünftiger Erweiterungen einzuschränken.

Bevorzugt hält die freie Kapazität Funktionsblöcke höchster Relevanz zweifach redundant, Funktionsblöcke hoher Relevanz einfach redundant und Funktionsblöcke geringer Relevanz nicht redundant vor. Eine weitere Steigerung der Zuverlässigkeit bei gleichzeitiger Einsparung von Kapazität ist so möglich.

Vorteilhafterweise hält nahezu die gesamte freie Kapazität redundante Funktionsblöcke vor. So werden die maximal mögliche Redundanz und damit die maximale Zuverlässigkeit erreicht.

Bevorzugt weist das Flugfunkgerät weiterhin einen Fehlerdetektor auf. Bevorzugt detektiert der Fehlerdetektor Fehler der von dem dynamisch rekonfigurierbaren Schaltungselement realisierten Funktionsblöcke. Das dynamisch rekonfigurierbare Schaltungselement rekonfiguriert bevorzugt fehlerbehaftete Funktionsblöcke ohne Funktionsunterbrechung des Flugfunkgeräts dynamisch. So werden fehlerhafte Funktionsblöcke ermittelt und korrigiert. Eine dauerhaft fehlerhafte Funktion wird damit vermieden. Dies erhöht zusätzlich die Zuverlässigkeit.

Vorteilhafterweise ist das dynamisch rekonfigurierbare Schaltungselement ein FPGA. Ein Einsatz von Standardtechnologie ist so möglich.

Bevorzugt beinhaltet das Flugfunkgerät weiterhin einen Fehlerspeicher. Der Fehlerspeicher zeichnet vorteilhafterweise das Auftreten von Fehlern in verschiedenen Bereichen des dynamisch rekonfigurierbaren Schaltungselements auf. Das Flugfunkgerät sperrt bevorzugt bei Überschreiten einer bestimmten Häufigkeit des Auftretens von Fehlern in bestimmten Bereichen des dynamisch rekonfigurierbaren Schaltungselements diese Bereiche. Das dynamisch rekonfigurierbare Schaltungselement rekonfiguriert Funktionsblöcke, welche durch gesperrte Bereiche realisiert sind, in nicht gesperrten Bereichen. So werden fehlerträchtige Bereiche des FPGA nicht länger genutzt, was die Zuverlässigkeit des Systems weiter erhöht.

Vorteilhafterweise erfolgt die Auswahl der Funktionsblöcke zur Designzeit des Systems nach vorab festgelegten Sicherheitsprioritäten.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: ein Blockschaltbild eines beispielhaften Flugfunkgeräts;
- Fig. 2: ein Blockschaltbild der FPGA-Feldprogrammierung eines ersten Ausführungsbeispiels des erfindungsgemäßen Flugfunkgeräts;
- Fig. 3: ein Blockschaltbild der FPGA-Feldprogrammierung eines zweiten Ausführungsbeispiels des erfindungsgemäßen Flugfunkgeräts;
- Fig. 4: ein Blockschaltbild der FPGA-Feldprogrammierung eines dritten Ausführungsbeispiels des erfindungsgemäßen Flugfunkgeräts;
- Fig. 5: ein Blockschaltbild der FPGA-Feldprogrammierung eines vierten Ausführungsbeispiels des erfindungsgemäßen Flugfunkgeräts;
- Fig. 6: ein Blockschaltbild der FPGA-Feldprogrammierung eines fünften Ausführungsbeispiels des erfindungsgemäßen Flugfunkgeräts;
- Fig. 7: ein Blockschaltbild der FPGA-Feldprogrammierung eines sechsten Ausführungsbeispiels des erfindungsgemäßen Flugfunkgeräts;
- Fig. 8: ein Ablaufdiagramm eines ersten Ausführungsbeispiels des erfindungsgemäßen Verfahrens, und
- Fig. 9: ein Ablaufdiagramm eines zweiten Ausführungsbeispiels des erfindungsgemäßen Verfahrens.

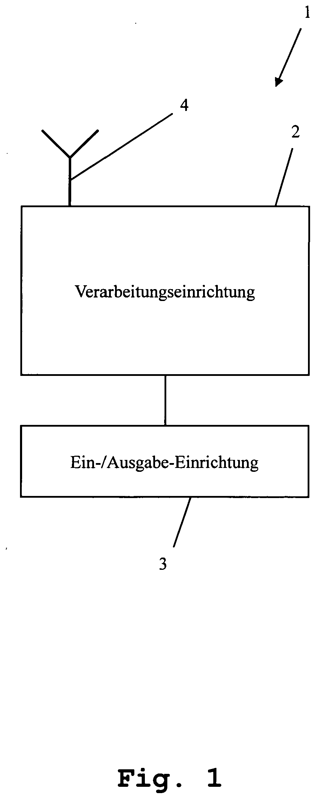

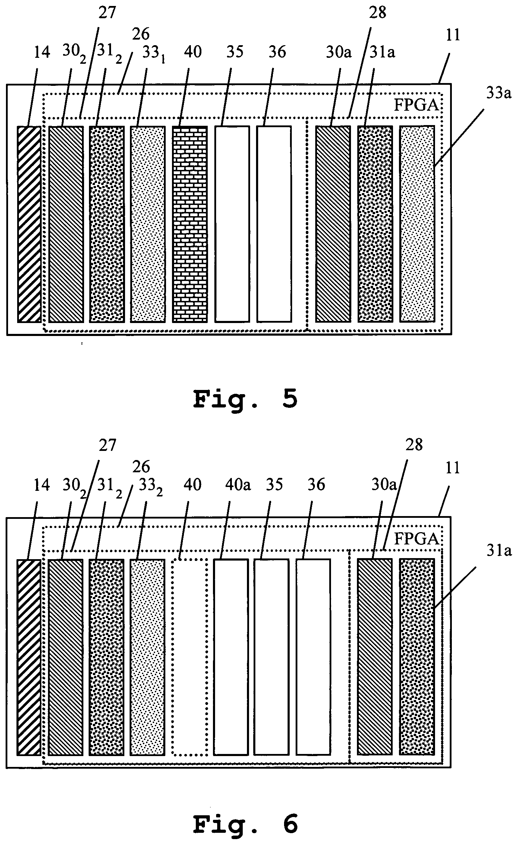

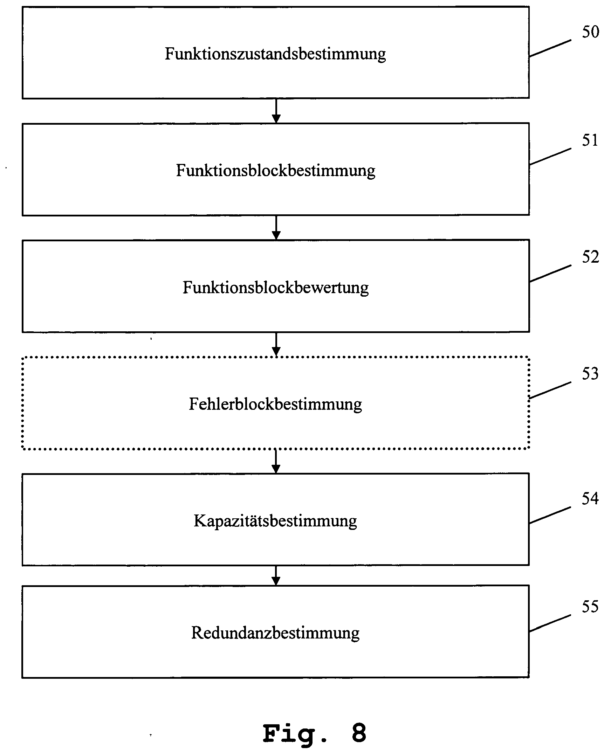

Zunächst wird anhand der Fig. 1 - 4 der generelle Aufbau und die Funktionsweise der erfindungsgemäßen Vorrichtung erläutert. Anhand der Fig. 5 - 7 wird anschließend der Aufbau und die Funktionsweise in bestimmten Betriebsfällen gezeigt. Abschließend wird anhand der Fig. 8 - 9 die Funktionsweise des erfindungsgemäßen Verfahrens erläutert. Identische Elemente wurden in ähnlichen Abbildungen zum Teil nicht wiederholt dargestellt und beschrieben.

Fig. 1 zeigt ein Blockschaltbild eines beispielhaften Flugfunkgeräts. Eine Antenne 4 ist mit einer Verarbeitungseinrichtung 2 verbunden. Die Verarbeitungseinrichtung 2 ist mit einer Ein-/AusgabeEinrichtung 3 verbunden. Mittels der Ein-/AusgabeEinrichtung 3 werden Informationen von dem Flugfunkgerät 1 empfangen bzw. an das Flugfunkgerät 1 übertragen. Bei Informationen kann es sich um Sprache aber auch digitale Daten handeln. Die Verarbeitungseinrichtung 2 verarbeitet die Informationen. Die Informationen werden als Signale von der Antenne 4 empfangen bzw. von der Antenne 4 gesendet. Auf Grund der großen Höhe des Einsatzes ist das Flugfunkgerät 1 einer erhöhten Strahlung durch Höhenstrahlung ausgesetzt. Dies kann zu Fehlern in der Verarbeitung in der Verarbeitungseinrichtung führen. Solche Fehler können die Funktion des Flugfunkgeräts 1 beeinträchtigen. Insbesondere bei Einsatz von FPGAs in der Verarbeitungseinrichtung, wie dies bei Software-Defined-Radio (SDR) üblich ist, sind Defekte durch Höhenstrahlung häufig, da die Speicher der FPGAs durch hochenergetische Teilchen umgeladen werden können. Zur Beseitigung eines solchen Fehlers ist üblicherweise eine Wartung des Geräts notwendig, in deren Rahmen eine Neuaufspielung der Software und Firmware erfolgen muss.

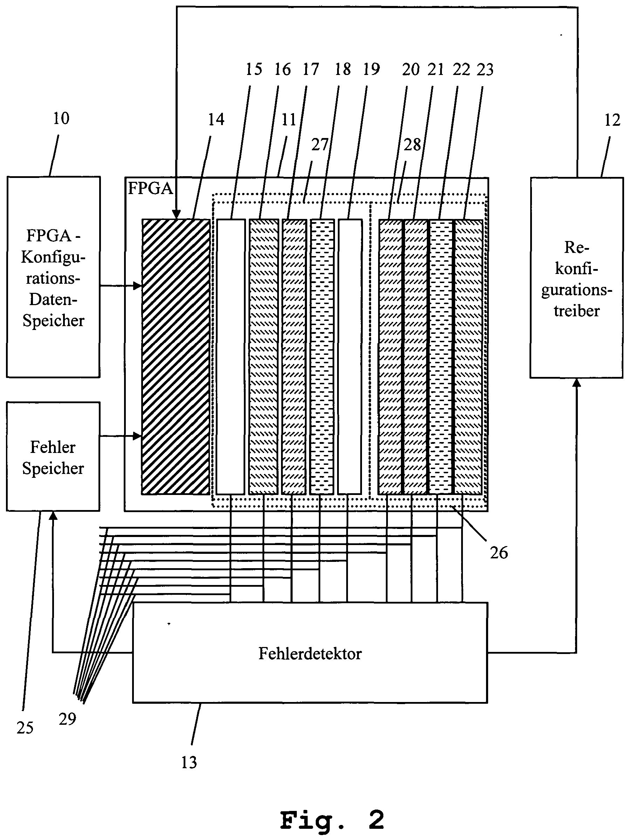

In Fig. 2 wird ein Blockschaltbild der FPGA-Feldprogrammierung eines ersten Ausführungsbeispiels des erfindungsgemäßen Flugfunkgeräts gezeigt. Der hier gezeigte Ausschnitt entspricht funktionell zumindest einem Teil der Verarbeitungseinrichtung 2 aus Fig. 1. Ein dynamisch rekonfigurierbares Schaltungselement 11, hier ein FPGA, ist mit einem Konfigurationsdatenspeicher 10 einem Fehlerspeicher 25, einem Rekonfigurationstreiber 12 und einem Fehlerdetektor 13 verbunden. Das rekonfigurierbare Schaltungselement 11 ist weiterhin mit den Leitungen 29 verbunden. Die Leitungen 29 dienen der Übertragung von Signalen zwischen dem rekonfigurierbaren Schaltungselement 11 und weiteren nicht dargestellten Schaltungselementen. Gleichzeitig werden von diesen Leitungen 29 die Eingangssignale des Fehlerdetektors 13 abgegriffen. Das FPGA beinhaltet eine fest verdrahtete Konfigurationseinrichtung 14 und einen dynamisch rekonfigurierbaren Bereich 26. In diesem Beispiel sind in dem dynamisch rekonfigurierbaren Bereich 26 mehrere Funktionsblöcke 15 - 19 und mehrere redundante Funktionsblöcke 20 - 23 realisiert. Dieses Beispiel entspricht jedoch lediglich einem Funktionszustand. Zum Betrieb eines erfindungsgemäßen Flugfunkgeräts können mehrere unterschiedliche Funktionszustände genutzt werden. Bei dem Wechsel zwischen Funktionszuständen wird der dynamisch rekonfigurierbare Bereich 26 rekonfiguriert. Funktionsblöcke werden ersetzt, hinzugefügt oder entfernt. Die Rekonfiguration findet im Betrieb statt.

Die Funktionsblöcke 15 - 19 sind hier funktionskritische Funktionsblöcke. D.h. diese Funktionsblöcke 15 - 19 sind für die einwandfreie Funktion des Funkgeräts 1 notwendig. Der von ihnen eingenommene Bereich 27 auf dem FPGA ist jedoch kleiner als der dynamisch rekonfigurierbare Bereich 26. Die freie Kapazität 28 auf dem FPGA wird zur Vorhaltung von redundanten Funktionsblöcken 20 - 23 genutzt.

Die Funktionsblöcke sind dabei nicht in ihrer Größe, Anzahl und Position festgelegt. Eine beliebige Anzahl an Funktionsblöcken beliebiger Größe kann an beliebiger Position innerhalb des FPGA erstellt werden. Die einzige Limitierung ist die verfügbare Kapazität des FPGA. Die hier dargestellten Funktionsblöcke 15 - 23 sind lediglich beispielhafte Funktionsblöcke einer möglichen Konfiguration.

In dem Konfigurationsspeicher 10 sind mögliche Konfigurationen des FPGA gespeichert. Dieser Speicher weist eine hohe Fehlerresistenz auf. Insbesondere ist dieser Speicher relativ unempfindlich gegenüber Strahlung. Beispielsweise besteht der Konfigurationsspeicher 10 aus Flash-Bausteinen.

Die Konfigurationseinrichtung 14 ist ein fest verdrahteter Bereich des FPGA. Eine Rekonfiguration ist hier nicht möglich. Die Konfigurationseinrichtung 14 beinhaltet die für die Rekonfiguration notwendigen Schaltungen.

Um eine hohe Fehlerresistenz des Flugfunkgeräts zu erzielen, werden besonders kritische Funktionsblöcke 16 - 18 jeweils mehrmals innerhalb des FPGA vorgehalten. So entsprechen die Funktionsblöcke 20 - 23 den Funktionsblöcken 16 - 18. Dabei sind die Funktionsblöcke 16 und 18 einfach redundant als Funktionsblöcke 22 und 23 realisiert. Der Funktionsblock 17 ist zweifach redundant als Funktionsblöcke 20 und 21 realisiert. Eine dreifache oder n-fache Redundanz ist ebenfalls möglich.

Durch die redundante Auslegung können Fehler detektiert bzw. behoben werden. Der Funktionsblock 16 ist identisch als Funktionsblock 23 vorhanden. Durch zweifache Vorhaltung ist eine Detektion von Fehlern in den Ausgangssignalen der Funktionsblöcke 16 und 23 möglich, wenn sie sich unterscheiden. Eine Korrektur von Fehlern ist so jedoch nicht möglich, da nicht bestimmt werden kann, welcher der Funktionsblöcke 16 und 23 ein fehlerhaftes Ergebnis liefert. Der Funktionsblock 17 ist zusätzlich als redundante Funktionsblöcke 20 und 21 in dreifacher Ausführung vorhanden. So kann bei unterschiedlichen Ausgangssignalen der Funktionsblöcke 17, 20 und 21 der fehlerhafte Funktionsblock, der Funktionsblock mit dem Minderheitensignal, bestimmt werden. Das identische Ausgangssignal der beiden verbleibenden Funktionsblöcke wird als korrektes Ausgangssignal angesehen. Auch eine Vorhaltung noch höherer Redundanz ist denkbar, um z.B. zwei fehlerhafte Funktionsblöcke ausgleichen zu können.

Der Fehlerdetektor 13 besteht aus einer Reihe von Vergleichern, welche die Ausgangssignale des FPGA miteinander vergleichen. So vergleicht er die Ausgangssignale der Funktionsblöcke 16 und 23 miteinander. Ebenso vergleicht er die Ausgangssignale der Funktionsblöcke 17, 20 und 21 miteinander. Stellt der Fehlerdetektor eine Abweichung der Ausgangswerte der redundanten Funktionsblöcke fest, so meldet er ein Fehlerereignis an Fehlerspeicher 25 und den Rekonfigurationstreiber 12. Der Fehlerspeicher 25 speichert den Ort des Auftretens des Fehlers auf dem dynamisch rekonfigurierbaren Schaltungselement 11.

Der Rekonfigurationstreiber 12 stößt ausgehend von dem Fehlerereignis die Rekonfiguration des betroffenen fehlerhaften Funktionsblocks an. Kann der Fehler korrigiert werden, so wird die Signalverarbeitung durch das FPGA uneingeschränkt fortgesetzt. Kann der Fehler nicht korrigiert werden, so wird der entsprechende Schritt der Signalverarbeitung nach der Rekonfiguration oder von einem anderen Funktionsblock wiederholt. Der Rekonfigurationstreiber 12 übermittelt den zu rekonfigurierenden Konfigurationsblock an die Konfigurationseinrichtung 14 auf dem FPGA, welcher die eigentliche Rekonfiguration durchführt.

Die Konfigurationseinrichtung 14 lädt die zur Rekonfiguration benötigten Daten aus dem Konfigurationsspeicher 10 und erzeugt neue Funktionsblöcke auf dem FPGA. Dies kann im Fall eines Fehlers an derselben Position erfolgen, an welcher ein identischer Funktionsblock bereits zuvor gespeichert war. Weiterhin kann ein Auslesen des Fehlerspeichers 25 erfolgen. Wird eine hohe Anzahl an Fehlern für einen bestimmten Bereich des FPGA festgestellt, so werden neue Funktionsblöcke nicht in diesem Bereich erzeugt.

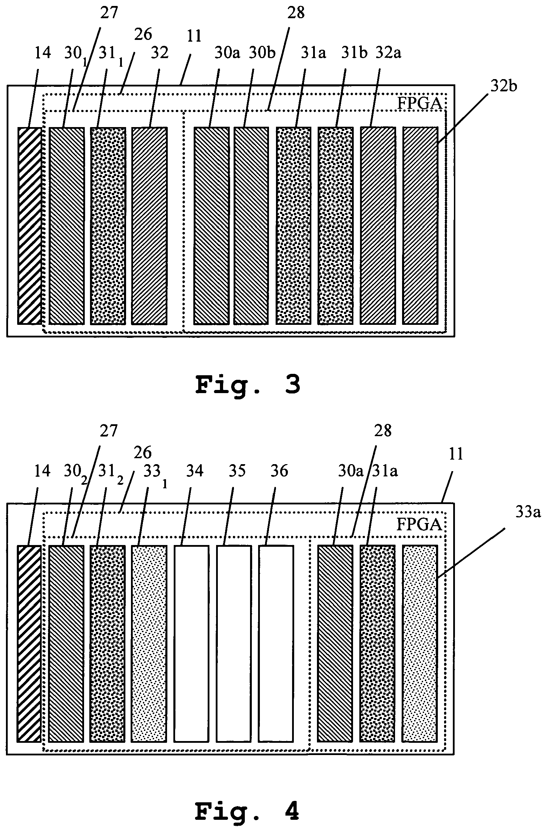

Der detaillierte Ablauf einer Rekonfiguration wird anhand der Fig. 3 - 6 näher erläutert.

Fig. 3 zeigt ein Blockschaltbild eines zweiten Ausführungsbeispiels der erfindungsgemäßen Vorrichtung. Hier ist lediglich das dynamisch rekonfigurierbare Schaltungselement 11 mit der Konfigurationseinrichtung 14 und dem frei rekonfigurierbaren Bereich 26 dargestellt. In der aktuellen Konfiguration sind die Konfigurationsblöcke 30₁, 31₁, 32, 30a, 30b, 31a, 31b, 32a und 32b konfiguriert. Die Funktionsblöcke 30₁, 31₁ und 32 sind dabei funktionskritische Funktionsblöcke. Die Funktionsblöcke 30a, 30b, 31a, 31b, 32a und 32b sind redundante Kopien der Funktionsblöcke 30₁, 31₁ und 32. Da die freie Kapazität 28 hier sehr groß ist, können sämtliche funktionskritische Funktionsblöcke 30₁, 31₁ und 32 in zweifacher Redundanz vorgehalten werden.

Ist die freie Kapazität auf Grund eines anderen Funktionszustands oder einer Erweiterung des ursprünglichen Funktionszustands, z.B. durch ein System-Upgrade reduziert, so ist eine Vorhaltung von einer derart hohen Redundanz nicht länger möglich. Dies wird anhand der Fig. 4 dargestellt.

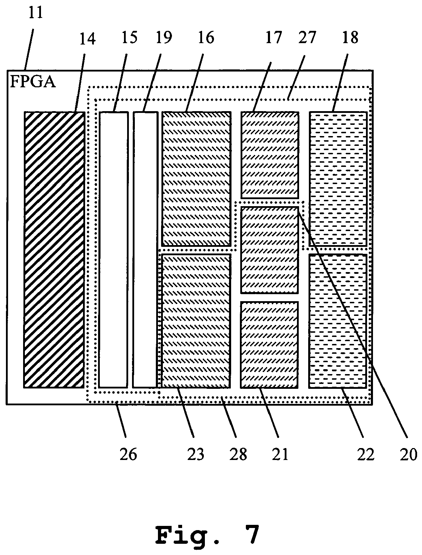

In Fig. 4 wird ein Blockschaltbild eines dritten Ausführungsbeispiels der erfindungsgemäßen Vorrichtung gezeigt. Diese Darstellung entspricht zu weiten Teilen der Darstellung aus Fig. 3. Die zusätzlichen funktionskritischen Funktionsblöcke 34, 35 und 36 wurden in dem hier dargestellten Funktionszustand hinzugefügt. Dies führt zu einem größeren Bereich 27, welcher durch die funktionskritischen Funktionsblöcke belegt ist. Damit ist die freie Kapazität 28 geringer. Sie genügt hier nur lediglich zur Vorhaltung von einfacher Redundanz für die wichtigsten Funktionsblöcke 30₂, 31₂, 33₁. So sind die Funktionsblöcke 30₂, 31₂ und 32 als redundante Kopien 30a, 31a und 33a realisiert. Um zu bestimmen, welche Funktionsblöcke mit welcher Redundanz vorgehalten werden, wird vor der Rekonfiguration eine Analyse durchgeführt, in deren Rahmen die Relevanz der jeweiligen Funktionsblöcke für die Systemsicherheit des Flugfunkgeräts bestimmt wird. Hierauf wird anhand der Fig. 7 näher eingegangen.

Fig. 5 zeigt ein Blockschaltbild eines vierten Ausführungsbeispiels der erfindungsgemäßen Vorrichtung. Diese Darstellung entspricht weitgehend der Darstellung aus Fig. 4. An der Position des Funktionsblocks 34 aus Fig. 4, welche hier der fehlerhafte Funktionsblock 40 innehat, wurden durch den Fehlerdetektor 13 aus Fig. 2 in der Vergangenheit bereits mehrfach Fehler detektiert und in dem Fehlerspeicher 25 aus Fig. 2 gespeichert. Bei einer erneuten Rekonfiguration wird diese Position von der Konfigurationseinrichtung 14 nach Auslesen des Fehlerspeichers 25 nicht länger genutzt, falls genügend Ressourcen an anderer Position auf dem FPGA verfügbar sind. Da die freie Kapazität 28 bei dieser Konfiguration genügend groß ist, wird der fehlerhafte Funktionsblock 40 in einem folgenden Schritt in einem anderen Bereich des FPGA rekonfiguriert. Dies wird anhand von Fig. 6 gezeigt.

In Fig. 6 wird ein Blockschaltbild eines fünften Ausführungsbeispiels der erfindungsgemäßen Vorrichtung gezeigt. Hier ist die Situation aus Fig. 5 nach der Rekonfiguration zur Beseitigung des fehlerhaften Funktionsblocks 40 dargestellt. Die Position, an welcher der Funktionsblock 40 konfiguriert war, wird nicht länger genutzt. Sie wurde als fehleranfällig detektiert. Stattdessen wird ein dem Funktionsblock 40 identischer Funktionsblock 40a an anderer Position auf dem FPGA konfiguriert. Genügt der auf dem FPGA verfügbare Raum nicht, so muss zwischen einer Reduktion der Redundanz von Funktionsblöcken und einer Inkaufnahme einer erhöhten Fehlerwahrscheinlichkeit bei Nutzung der fehleranfälligen ursprünglichen Position abgewogen werden.

Um diese Entscheidung zu treffen, können zusätzlich Fehlerwahrscheinlichkeitsrechnungen aufgestellt werden oder auf eine vorab erstellte Prioritätsreihenfolge zurückgegriffen werden. In dem hier dargestellten Beispiel wurde zu Gunsten der reduzierten Redundanz entschieden. Somit wurde der fehlerhafte Funktionsblock 40 an anderer Stelle rekonfiguriert. Um den verloren gegangenen Platz auszugleichen, wurde die redundante Kopie des Funktionsblocks 33₁ aus Fig. 5, der Funktionsblock 33a entfernt. Nun liegen lediglich die Funktionsblöcke 30₂ und 31₂ in einfach redundanter Form vor.

In Fig. 7 wird ein Blockschaltbild eines sechsten Ausführungsbeispiels der erfindungsgemäßen Vorrichtung gezeigt. Die Funktionsblöcke 15 bis 19 und die redundanten Funktionsblöcke 20 bis 23 entsprechen weitgehend den Funktionsblöcken und redundanten Funktionsblöcken aus Fig. 2. Zur Vereinfachung der Zuordnung der Funktionsblöcke zur Lage innerhalb des dynamisch rekonfigurierbaren Schaltungselements 11 werden redundante Funktionsblöcke 20 bis 23 in derselben FPGA-Spalte angeordnet wie die entsprechenden Funktionsblöcke 15 bis 19. Im Fall von einfacher Redundanz befinden sich 2 identische Funktionsblöcke 16 und 23, 18 und 22 in derselben Spalte. Im Fall von zweifacher Redundanz befinden sich 3 identische Funktionsblöcke 17, 20, 21 in derselben Spalte. Die Zuordnungsvorschrift bei Auftreten eines fehlerhaften Bereichs, also der Rekonfigurationsbereich der zugehörigen Funktion ist ressourcensparend im Rekonfigurationstreiber 12 aus Fig. 2 abgelegt.

Fig. 8 zeigt ein Ablaufdiagramm eines ersten Ausführungsbeispiels des erfindungsgemäßen Verfahrens. In einem ersten Schritt 50 werden die verschiedenen Funktionszustände des Flugfunkgeräts bestimmt. Ein Funktionszustand ist dabei ein auf eine bestimmte Funktion des Flugfunkgeräts spezialisierter Zustand, z.B. ein Zustand zum verschlüsselten Senden. In einem zweiten Schritt 51 werden die für die verschiedenen Funktionszustände benötigten Funktionsblöcke bestimmt. Funktionsblöcke sind dabei einzelne für die Funktion notwendigen Einheiten, z.B. ein BPSK-Modulationsblock.

Anschließend findet in einem dritten Schritt 52 eine Bewertung der Funktionsblöcke der Funktionszustände hinsichtlich ihrer Relevanz für die Systemsicherheit des Flugfunkgeräts statt. Dies kann in Abhängigkeit von verschiedenen Anwendungsfällen geschehen. So ist z.B. bei einer geplanten Landung des Flugzeugs eine unterschiedliche Funktionalität des Flugfunkgeräts sicherheitskritisch als bei einem Überlandflug. Die Resultate dieser Bewertung werden gespeichert. In einem optionalen vierten Schritt 53 werden Fehlerblöcke des dynamisch rekonfigurierbaren Schaltelements 11, hier des FPGAs, bestimmt. Dies ist für die folgenden Schritte relevant, da hierdurch verfügbare Kapazität verloren geht.

So wird, wie anhand von Fig. 2 beschrieben, das häufige Auftreten von Fehlern in bestimmten Bereichen des dynamisch rekonfigurierbaren Schaltelements aus dem Fehlerspeicher ausgelesen und die entsprechenden Bereiche des dynamisch rekonfigurierbaren Schaltelements gesperrt.

In einem anschließenden fünften Schritt 54 wird die freie Kapazität für jeden Funktionszustand des Flugfunkgeräts ermittelt. Dies geschieht durch Subtraktion der für die im zweiten Schritt 51 ermittelten Funktionsblöcke benötigten Kapazität und der Kapazität der im optionalen vierten Schritt 53 bestimmten fehlerhaften Bereiche von der Gesamtkapazität des dynamisch rekonfigurierbaren Schaltelements. Anschließend wird in einem sechsten Schritt 55 die einzusetzende Redundanz bestimmt. Ausgerichtet an der im dritten Schritt 52 durchgeführten Bewertung der Funktionsblöcke wird in Abhängigkeit des jeweiligen Anwendungsfalls bestimmt, welche Funktionsblöcke der einzelnen Funktionszustände in der verfügbaren freien Kapazität des dynamisch rekonfigurierbaren Schaltelements redundant vorzuhalten sind. So werden sehr relevante Funktionsblöcke mit hoher Redundanz, z.B. zweifacher Redundanz, vorgehalten. Weniger wichtige Funktionsblöcke werden lediglich mit einfacher Redundanz oder ohne Redundanz vorgehalten. Je geringer die freie Kapazität ist, desto geringer ist auch die Anzahl an redundant vorgehaltenen Funktionsblöcken. Dabei werden die relevantesten Funktionsblöcke mit Priorität behandelt.

Die Schritte 50 - 52 werden typischerweise vor Inbetriebnahme des Flugfunkgeräts durchgeführt. Z.B. im Rahmen einer Vorkonfiguration durch den Hersteller. Der Schritt 52, die Blockbewertung, kann dabei zur Berücksichtigung von spezifischen Anwendungsfällen auch im Betrieb durchgeführt werden. Die Schritte 53 - 55 werden ebenfalls im Betrieb durchgeführt.

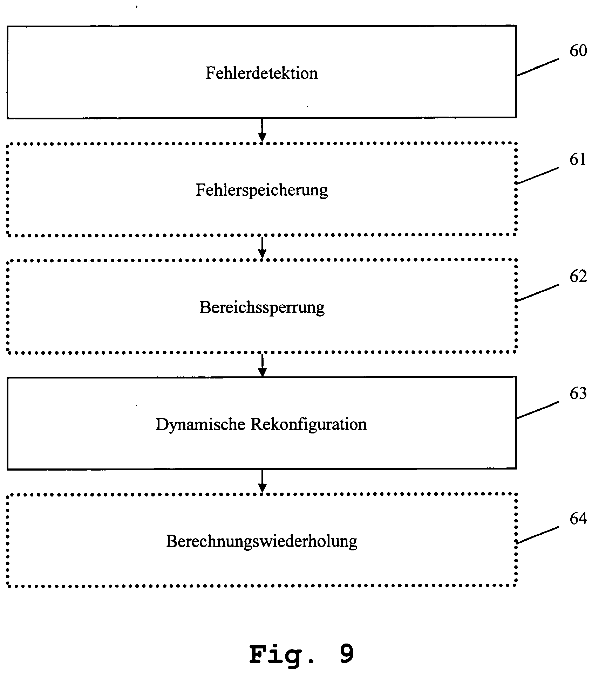

Fig. 9 zeigt ein zweites Ausführungsbeispiel des erfindungsgemäßen Verfahrens in einem Blockdiagramm. Die hier dargestellten Schritte sind notwendig, um den Schritt 53 aus Fig. 8 durchführen zu können. In einem ersten Schritt 60 werden Fehler in den Ausgangssignalen der auf dem dynamisch rekonfigurierbaren Schaltungselement integrierten Funktionsblöcke detektiert. Die folgenden Schritte werden nur durchgeführt, wenn in dem ersten Schritt 60 ein Fehler detektiert wurde. Die Fehlerdetektion geschieht durch Vergleich der Ausgangssignale der redundanten Funktionsblöcke. Alternativ ist eine aufwendigere Fehlerdetektion durch eine Überprüfung der Ausgangssignale möglich. Insbesondere bei nicht redundanten Funktionsblöcken kann dieses Vorgehen vorteilhaft sein.

In einem zweiten optionalen Schritt 61 wird das Auftreten von Fehlern gespeichert. Hierzu wird ein fehlerresistenter Fehlerspeicher eingesetzt. Neben dem Auftreten des Fehlers wird die Position des aufgetretenen Fehlers auf dem FPGA bestimmt und gespeichert. Die Positionsbestimmung erfolgt durch Heranziehen der Position des betroffenen Funktionsblocks. Kann der genaue Funktionsblock, in welchem der Fehler aufgetreten ist, nicht ermittelt werden (s. u.), so wird als Fehlerposition die Position der beteiligten Funktionsblöcke gespeichert. Eine genauere Positionsbestimmung findet nicht statt.

In einem optionalen dritten Schritt 62 werden Bereiche des FPGAs, in welchen laut dem Fehlerspeicher gehäuft Fehler auftreten, gesperrt. Z.B. bei Überschreitung einer bestimmten Schwelle der Fehlerhäufigkeit oder Fehlerdichte wird ein Bereich des FPGA somit als fehleranfällig eingestuft. Diese Sperrung führt zu einer Rekonfiguration der in den jeweiligen Bereichen befindlichen Funktionsblöcke in anderen Bereichen im folgenden Schritt 63.

In einem vierten Schritt 63 findet eine dynamische Rekonfiguration statt. Die fehlerbehafteten Funktionsblöcke werden an gleicher oder neuer Position neu erstellt. Derweil verbleibt der übrige FPGA in Funktion. Die Funktionalität des Flugfunkgeräts wird nicht eingeschränkt. Kann der genaue Funktionsblock ermittelt werden, in welchem der Fehler aufgetreten ist, so wird nur dieser Funktionsblock rekonfiguriert. Dies ist z.B. der Fall, wenn ein besonders kritischer Funktionsblock zweifach redundant, also insgesamt 3-mal vorhanden ist. Ergibt sich ein abweichendes Ergebnis, so wird der abweichende Funktionsblock rekonfiguriert. Kann der genaue Funktionsblock, in welchem der Fehler aufgetreten ist, nicht ermittelt werden, so werden sämtliche Funktionsblöcke, in welchen der Fehler aufgetreten sein könnte, rekonfiguriert. Dies ist z.B. bei einfach redundanten Funktionsblöcken der Fall.

In einem optionalen fünften Schritt 64 werden Berechnungsschritte, welche durch einen Fehler unterbrochen wurden, nachgeholt, sofern der Fehler nicht auf Grund von Redundanz ausgeglichen werden konnte. Die rekonfigurierten Funktionsblöcke führen die ursprünglichen Berechnungen, bei welchen der Fehler aufgetreten ist, ausgehend von den ursprünglichen Eingangssignalen erneut durch und leiten die Ausgangssignale weiter. Da die Rekonfiguration sehr schnell erfolgt, führt das Auftreten eines Fehlers nicht zu einer Funktionsunterbrechung des Funkgeräts, sondern lediglich zu einer kurzfristigen Verzögerung in der internen Verarbeitung der Signale, welche jedoch ausgeglichen und von dem Nutzer nicht bemerkt wird.

Die Erfindung ist nicht auf das dargestellte Ausführungsbeispiel beschränkt. Wie bereits erwähnt, können unterschiedliche dynamisch rekonfigurierbare Schaltelemente eingesetzt werden. Auch ein Einsatz von mehrfach-redundanten Funktionsblöcken ist denkbar. Eine Kombination mit Watchdog-Schaltungen ist ebenfalls möglich. Auch ein Einsatz außerhalb von Flugfunkanwendungen ist denkbar. Insbesondere in Umgebungen mit hoher Strahlung oder sehr hohen Sicherheitsanforderungen ist ein Einsatz denkbar. Alle vorstehend beschriebenen Merkmale oder in den Figuren gezeigten Merkmale sind im Rahmen der Erfindung beliebig vorteilhaft miteinander kombinierbar.

## Patentansprüche

1. Flugfunkgerät (1) mit einem dynamisch rekonfigurierbaren Schaltungselement (11) mit einer vorgegebenen Kapazität,
wobei das Flugfunkgerät (1) mehrere Funktionszustände mit jeweils mehreren Funktionsblöcken (15 - 19, 30₁, 30₂, 31₁, 31₂, 32, 33, 34, 35, 36, 40, 40a) aufweist,
wobei das dynamisch rekonfigurierbare Schaltungselement (11) zumindest einen Funktionsblock (15 - 19, 30₁, 30₂, 31₁, 31₂, 32, 33, 34, 35, 36, 40, 40a) realisiert,
wobei jeder von dem dynamisch rekonfigurierbaren Schaltungselement (11) realisierte Funktionsblock (15 - 19, 30₁, 30₂, 31₁, 31₂, 32, 33, 34, 35, 36, 40, 40a) eine bestimmte Kapazität des dynamisch rekonfigurierbaren Schaltungselements (11) nutzt,
wobei die Differenz der vorgegebenen Kapazität des dynamisch rekonfigurierbaren Schaltungselements (11) und der maximal benötigten Kapazität der Funktionsblöcke (15 - 19, 30₁, 30₂, 31₁, 31₂, 32, 33, 34, 35, 36, 40, 40a) der Funktionszustände eine freie Kapazität (28) bildet,
wobei die freie Kapazität (28) redundante Funktionsblöcke (20 - 23, 30a, 30b, 31a, 31b, 32a, 32b, 33a) vorhält, wobei die redundanten Funktionsblöcke (20 - 23, 30a, 30b, 31a, 31b, 32a, 32b, 33a) dynamisch rekonfigurierbar sind, wobei die Funktionsblöcke (15 - 19, 30₁, 30₂, 31₁, 31₂, 32, 33, 34, 35, 36, 40, 40a) der Funktionszustände des Flugfunkgeräts (1) in Abhängigkeit von bestimmten Anwendungsfällen nach ihrer Relevanz für eine Systemsicherheit bewertet sind,
wobei die freie Kapazität (28) die redundanten Funktionsblöcke (20 - 23, 30a, 30b, 31a, 31b, 32a, 32b, 33a) in Abhängigkeit von der Relevanz für die bestimmten Anwendungsfälle redundant vorhält.

2. Flugfunkgerät nach Anspruch 1,
**dadurch gekennzeichnet,**
**dass** die freie Kapazität (28) Funktionsblöcke (17, 30₁, 31₁, 32) höchster Relevanz zweifach redundant vorhält, dass die freie Kapazität (28) Funktionsblöcke (16, 18, 30₂, 31₂, 33₁) hoher Relevanz einfach redundant vorhält, und
**dass** die freie Kapazität (28) Funktionsblöcke (19, 35, 36, 40, 40a) geringer Relevanz nicht redundant vorhält.

3. Flugfunkgerät nach Anspruch 1 oder 2,
**dadurch gekennzeichnet,**
**dass** nahezu die gesamte freie Kapazität (28) redundante Funktionsblöcke (20 - 23, 30a, 30b, 31a, 31b, 32a, 32b, 33, 33a) vorhält.

4. Flugfunkgerät nach einem der Ansprüche 1 bis 3,
**dadurch gekennzeichnet,**
**dass** das Flugfunkgerät (1) weiterhin einen Fehlerdetektor (13) aufweist,
**dass** der Fehlerdetektor (13) Fehler der von dem dynamisch rekonfigurierbaren Schaltungselement (11) realisierten Funktionsblöcke (15 - 19, 30, 31, 32, 33, 34, 35, 36, 40, 40a) detektiert, und
**dass** das dynamisch rekonfigurierbare Schaltungselement (11) fehlerbehaftete Funktionsblöcke (40) ohne Funktionsunterbrechung des Flugfunkgeräts (1) dynamisch rekonfiguriert.

5. Flugfunkgerät nach einem der Ansprüche 1 bis 4,
**dadurch gekennzeichnet,**
**dass** das dynamisch rekonfigurierbare Schaltungselement (11) ein FPGA ist.

6. Flugfunkgerät nach einem der Ansprüche 1 bis 5,
**dadurch gekennzeichnet,**
**dass** das Flugfunkgerät (1) weiterhin einen Fehlerspeicher (25) beinhaltet,
**dass** der Fehlerspeicher das Auftreten von Fehlern in verschiedenen Bereichen des dynamisch rekonfigurierbaren Schaltungselements (11) aufzeichnet,
**dass** das Flugfunkgerät (1) bei Überschreiten einer bestimmten Häufigkeit des Auftretens von Fehlern in bestimmten Bereichen des dynamisch rekonfigurierbaren Schaltungselements (11) diese Bereiche sperrt, und
**dass** das dynamisch rekonfigurierbare Schaltungselement (11) Funktionsblöcke (40), welche durch gesperrte Bereiche realisiert sind, in nicht gesperrten Bereichen rekonfiguriert.

7. Verfahren zur dynamischen Rekonfiguration eines Flugfunkgeräts (1),
wobei das Flugfunkgerät (1) ein dynamisch rekonfigurierbares Schaltungselement (11) mit einer vorgegebenen Kapazität beinhaltet,
wobei das Flugfunkgerät (1) mehrere Funktionszustände mit jeweils mehreren Funktionsblöcken (15 - 19, 30, 31, 32, 33, 34, 35, 36, 40, 40a) aufweist,
wobei zumindest ein Funktionsblock (15 - 19, 30, 31, 32, 33, 34, 35, 36, 40, 40a) durch das dynamisch rekonfigurierbare Schaltungselement (11) realisiert wird,
wobei jeder durch das dynamisch rekonfigurierbare Schaltungselement (11) realisierte Funktionsblock (15 - 19, 30, 31, 32, 33, 34, 35, 36, 40, 40a) eine bestimmte Kapazität des dynamisch rekonfigurierbaren Schaltungselements (11) nutzt,
wobei die Differenz der vorgegebenen Kapazität des dynamisch rekonfigurierbaren Schaltungselements (11) und der maximal benötigten Kapazität der Funktionsblöcke (15 - 20, 30, 31, 32, 33, 34, 35, 36, 40, 40a) der. Funktionszustände eine freie Kapazität (28) bildet,
wobei redundante Funktionsblöcke (20 - 23, 30a, 30b, 31a, 31b, 32a, 32b, 33a) durch die freie Kapazität (28) vorgehalten werden,
wobei die redundanten Funktionsblöcke (20 - 23, 30a, 30b, 31a, 31b, 32a, 32b, 33a) dynamisch rekonfiguriert werden,
wobei die Funktionsblöcke (15 - 19, 30, 31, 32, 33, 33a, 34, 35, 36, 40, 40a) der Funktionszustände des Flugfunkgeräts (1) in Abhängigkeit von bestimmten Anwendungsfällen nach ihrer Relevanz für eine Systemsicherheit bewertet werden,
wobei die redundanten Funktionsblöcke (15 - 19, 30, 31, 32, 33, 33a, 34, 35, 36, 40, 40a) in Abhängigkeit von der Relevanz für die bestimmten Anwendungsfälle von der freien Kapazität (28) redundant vorgehalten werden.

8. Verfahren nach Anspruch 7,
**dadurch gekennzeichnet,**
**dass** Funktionsblöcke (17, 30₁, 31₁, 32) höchster Relevanz von der freien Kapazität (28) zweifach redundant vorgehalten werden,
**dass** Funktionsblöcke (16, 18, 30₂, 31₂, 33₁) hoher Relevanz von der freien Kapazität (28) einfach redundant vorgehalten werden, und
**dass** Funktionsblöcke (19, 33₂, 34, 35, 36, 40, 40a) geringer Relevanz von der freien Kapazität (28) nicht redundant vorgehalten werden.

9. Verfahren nach Anspruch 7 oder 8,
**dadurch gekennzeichnet,**
**dass** redundante Funktionsblöcke (20 - 23, 30a, 30b, 31a, 31b, 32a, 32b, 33a) von nahezu der gesamten freien Kapazität (28) vorgehalten werden.

10. Verfahren nach einem der Ansprüche 7 bis 9,
**dadurch gekennzeichnet,**
**dass** Fehler der von dem dynamisch rekonfigurierbaren Schaltungselement (11) realisierten Funktionsblöcke (15 - 19, 30, 31, 32, 33, 34, 35, 36, 40, 40a) detektiert werden, und
**dass** fehlerbehaftete Funktionsblöcke (40) durch das dynamisch rekonfigurierbare Schaltungselement (11) ohne Funktionsunterbrechung des Flugfunkgeräts (1) dynamisch rekonfiguriert werden.

11. Verfahren nach einem der Ansprüche 7 bis 10,
**dadurch gekennzeichnet,**
**dass** das Auftreten von Fehlern in verschiedenen Bereichen des dynamisch rekonfigurierbaren Schaltungselements (11) aufgezeichnet wird,
**dass** bei Überschreiten einer bestimmten Häufigkeit des Auftretens von Fehlern in bestimmten Bereichen des dynamisch rekonfigurierbaren Schaltungselements (11) diese Bereiche gesperrt werden, und
**dass** Funktionsblöcke (40), welche durch gesperrte Bereiche realisiert sind, in nicht gesperrten Bereichen rekonfiguriert werden.

## Claims

1. Aviation radio device (1) having a dynamically reconfigurable circuit element (11) with a given capacity,
wherein the aviation radio device (1) has a plurality of functional states each with a plurality of functional blocks (15 - 19, 30₁, 30₂, 31₁, 31₂, 32, 33, 34, 35, 36, 40, 40a), wherein the dynamically reconfigurable circuit element (11) creates at least one functional block (15 - 19, 30₁, 30₂, 31₁, 31₂, 32, 33, 34, 35, 36, 40, 40a),
wherein each functional block (15 - 19, 30₁, 30₂, 31₁, 31₂, 32, 33, 34, 35, 36, 40, 40a) created by the dynamically reconfigurable circuit element (11) uses a certain capacity of the dynamically reconfigurable circuit element (11),
wherein the difference between the given capacity of the dynamically reconfigurable circuit element (11) and the maximum required capacity of the functional blocks (15 - 19, 30₁, 30₂, 31₁, 31₂, 32, 33, 34, 35, 36, 40, 40a) of the functional states forms a free capacity (28),
wherein the free capacity (28) provides redundant functional blocks (20 - 23, 30a, 30b, 31a, 31b, 32a, 32b, 33a),
wherein the redundant functional blocks (20 - 23, 30a, 30b, 31a, 31b, 32a, 32b, 33a) are dynamically reconfigurable,
wherein the functional blocks (15 - 19, 30₁, 30₂, 31₁, 31₂, 32, 33, 34, 35, 36, 40, 40a) of the functional states of the aviation radio device (1) are rated depending on certain applications according to their relevance for system security,
wherein the free capacity (28) provides the redundant functional blocks (20 - 23, 30a, 30b, 31a, 31b, 32a, 32b, 33a) with redundancy depending on the relevance for the particular applications.

2. Aviation radio device according to claim 1,
**characterised in that** the free capacity (28) provides functional blocks (17, 31₁, 3₂) with the highest relevance with double redundancy,
**in that** the free capacity (28) provides functional blocks (16, 18, 30₂, 31₂, 33₁) with high relevance with single redundancy, and
**in that** the free capacity (28) provides functional blocks (19, 35, 36, 40, 40a) with low relevance with no redundancy.

3. Aviation radio device according to claim 1 or 2,
**characterised in that** almost all the free capacity (28) provides redundant functional blocks (20 - 23, 30a, 30b, 31a, 31b, 32a, 32b, 33, 33a).

4. Aviation radio device according to one of claims 1 to 3,
**characterised in that** the aviation radio device (1) also has an error detector (13),
**in that** the error detector (13) detects errors in the functional blocks (15 - 19, 30, 31, 32, 33, 34, 35, 36, 40, 40a) created by the dynamically reconfigurable circuit element (11), and
**in that** the dynamically reconfigurable circuit element (11) reconfigures functional blocks (40) with errors dynamically without any interruption in the function of the aviation radio device (1).

5. Aviation radio device according to one of claims 1 to 4,
**characterised in that** the dynamically reconfigurable circuit element (11) is an FPGA.

6. Aviation radio device according to one of claims 1 to 5,
**characterised in that** the aviation radio device (1) also contains an error memory (25),
**in that** the error memory records the incidence of errors in different areas of the dynamically reconfigurable circuit element (11),
**in that** if the incidence of errors in particular areas of the dynamically reconfigurable circuit element (11) exceeds a particular frequency, the aviation radio device (1) disables these areas, and
**in that** the dynamically reconfigurable circuit element (11) reconfigures functional blocks (40) created by disabled areas in areas which are not disabled.

7. Method for dynamic reconfiguration of an aviation radio device (1),
wherein the aviation radio device (1) contains a dynamically reconfigurable circuit element (11) with a given capacity,
wherein the aviation radio device (1) has a plurality of functional states each with a plurality of functional blocks (15 - 19, 30, 31, 32, 33, 34, 35, 36, 40, 40a),
wherein at least one functional block (15 - 19, 30, 31, 32, 33, 34, 35, 36, 40, 40a) is created by the dynamically reconfigurable circuit element (11),
wherein each functional block (15 - 19, 30, 31, 32, 33, 34, 35, 36, 40, 40a) created by the dynamically reconfigurable circuit element (11) uses a certain capacity of the dynamically reconfigurable circuit element (11),
wherein the difference between the given capacity of the dynamically reconfigurable circuit element (11) and the maximum required capacity of the functional blocks (15 - 19, 30, 31, 32, 33, 34, 35, 36, 40, 40a) of the functional states forms a free capacity (28),
wherein redundant functional blocks (20 - 23, 30a, 30b, 31a, 31b, 32a, 32b, 33a) are provided by the free capacity (28),
wherein the redundant functional blocks (20 - 23, 30a, 30b, 31a, 31b, 32a, 32b, 33a) are reconfigured dynamically,
wherein the functional blocks (15 - 19, 30, 31, 32, 33, 33a, 34, 35, 36, 40, 40a) of the functional sates of the aviation radio device (1) are rated depending on certain applications according to their relevance for system security,
wherein the redundant functional blocks (15 - 19, 30, 31, 32, 33, 33a, 34, 35, 36, 40, 40a) are provided by the free capacity (28) with redundancy depending on the relevance for the particular applications.

8. Method according to claim 7,
**characterised in that** functional blocks (17, 30₁, 31₁, 32) with the highest relevance are provided by the free capacity (28) with double redundancy,
**in that** functional blocks (16, 18, 30₂, 31₂, 33₁) with high relevance are provided by the free capacity (28) with single redundancy, and
**in that** functional blocks (19, 33₂, 34, 35, 36, 40, 40a) with low relevance are provided by the free capacity (28) with no redundancy.

9. Method according to claim 7 or 8,
**characterised in that** redundant functional blocks (20 - 23, 30a, 30b, 31a, 31b, 32a, 32b, 33a) are provided by almost all the free capacity (28).

10. Method according to one of claims 7 to 9,
**characterised in that** errors in the functional blocks (15 - 19, 30, 31, 32, 33, 34, 35, 36, 40, 40a) created by the dynamically reconfigurable circuit element (11) are detected, and
**in that** functional blocks (40) with errors are reconfigured by the dynamically reconfigurable circuit element (11) dynamically without any interruption in the function of the aviation radio device (1).

11. Method according to one of claims 7 to 10,
**characterised in that** the incidence of errors in different areas of the dynamically reconfigurable circuit element (11) is recorded,
**in that** if the incidence of errors in particular areas of the dynamically reconfigurable circuit element (11) exceeds a particular frequency, these areas are disabled, and
**in that** functional blocks (40) created by disabled areas are reconfigured in areas which are not disabled.

## Revendications

1. Appareil radio aérien (1) comportant un élément de commutation dynamiquement reconfigurable (11) ayant une capacité déterminée,
dans lequel l'appareil radio aérien (1) présente plusieurs états de fonctionnement ayant chacun plusieurs blocs fonctionnels (15 - 19, 30₁, 30₂, 31₁, 31₂, 32, 33, 34, 35, 36, 40, 40a),
dans lequel l'élément de commutation dynamiquement reconfigurable (11) réalise au moins un bloc fonctionnel (15 - 19, 30₁, 30₂, 31₁, 31₂, 32, 33, 34, 35, 36, 40, 40a),
dans lequel chaque bloc fonctionnel (15 - 19, 30₁, 30₂, 31₁, 31₂, 32, 33, 34, 35, 36, 40, 40a) réalisé par l'élément de commutation dynamiquement reconfigurable (11) exploite une capacité déterminée de l'élément de commutation dynamiquement reconfigurable (11),
dans lequel la différence entre la capacité déterminée de l'élément de commutation dynamiquement reconfigurable (11) et la capacité maximale exigée des blocs fonctionnels (15 - 19, 30₁, 30₂, 31₁, 31₂, 32, 33, 34, 35, 36, 40, 40a) des états de fonctionnement forme une capacité libre (28),
dans lequel la capacité libre (28) présente des blocs fonctionnels redondants (20 - 23, 30a, 30b, 31a, 31b, 32a, 32b, 33a),
dans lequel les blocs fonctionnels redondants (20 - 23, 30a, 30b, 31a, 31b, 32a, 32b, 33a) sont dynamiquement reconfigurables,
dans lequel les blocs fonctionnels (15 - 19, 30₁, 30₂, 31₁, 31₂, 32, 33, 34, 35, 36, 40, 40a) des états de fonctionnement de l'appareil radio aérien (1) sont évalués en fonction d'applications déterminées selon leur importance pour la sécurité du système,
dans lequel la capacité libre (28) présente en redondance les blocs fonctionnels redondants (20 - 23, 30a, 30b, 31a, 31b, 32a, 32b, 33a) en fonction de l'importance pour les applications déterminées.

2. Appareil radio aérien selon la revendication 1,
**caractérisé**
**en ce que** la capacité libre (28) présente en redondance deux fois les blocs fonctionnels (17, 30₁, 31₁, 32) d'importance maximale,
**en ce que** la capacité libre (28) présente en redondance une fois les blocs fonctionnels (16, 18, 30₂, 31₂, 33₁) d'importance élevée, et
**en ce que** la capacité libre (28) ne présente pas en redondance les blocs fonctionnels (19, 35, 36, 40, 40a) de faible importance.

3. Appareil radio aérien selon la revendication 1 ou 2,
**caractérisé**
**en ce que** pratiquement toute la capacité libre (28) présente les blocs fonctionnels redondants (20 - 23, 30a, 30b, 31a, 31b, 32a, 32b, 33, 33a).

4. Appareil radio aérien selon l'une des revendications 1 à 3,
**caractérisé**
**en ce que** l'appareil radio aérien (1) comporte en outre un détecteur d'erreurs (13),
**en ce que** le détecteur d'erreurs (13) détecte des erreurs des blocs fonctionnels (15 - 19, 30, 31, 32, 33, 34, 35, 36, 40, 40a) réalisés par l'élément de commutation dynamiquement reconfigurable (11), et
**en ce que** l'élément de commutation dynamiquement reconfigurable (11) reconfigure les blocs fonctionnels (40) défectueux sans interruption de fonctionnement de l'appareil radio aérien (1).

5. Appareil radio aérien selon l'une des revendications 1 à 4,
**caractérisé**
**en ce que** l'élément de commutation dynamiquement reconfigurable (11) est un FPGA.

6. Appareil radio aérien selon l'une des revendications 1 à 5,
**caractérisé**
**en ce que** l'appareil radio aérien (1) comprend en outre une mémoire d'erreurs (25),
**en ce que** la mémoire d'erreurs enregistre l'apparition d'erreurs dans différentes zones de l'élément de commutation dynamiquement reconfigurable (11),
**en ce que** l'appareil radio aérien (1) verrouille l'accès à des zones déterminées de l'élément de commutation dynamiquement reconfigurable (11) en cas de dépassement d'une fréquence définie d'apparition d'erreurs dans lesdites zones, et
**en ce que** l'élément de commutation dynamiquement reconfigurable (11) reconfigure dans des zones à accès non verrouillé les blocs fonctionnels (40) réalisés par des zones à accès verrouillé.

7. Procédé de reconfiguration dynamique d'un appareil radio aérien (1),
dans lequel l'appareil radio aérien (1) comprend un élément de commutation dynamiquement reconfigurable (11) ayant une capacité déterminée,
dans lequel l'appareil radio aérien (1) présente plusieurs états de fonctionnement ayant chacun plusieurs blocs fonctionnels (15 - 19, 30, 31, 32, 33, 34, 35, 36, 40, 40a),
dans lequel au moins un bloc fonctionnel (15 - 19, 30, 31, 32, 33, 34, 35, 36, 40, 40a) est réalisé par l'élément de commutation dynamiquement reconfigurable (11),
dans lequel chaque bloc fonctionnel (15 - 19, 30, 31, 32, 33, 34, 35, 36, 40, 40a) réalisé par l'élément de commutation dynamiquement reconfigurable (11) exploite une capacité déterminée de l'élément de commutation dynamiquement reconfigurable (11),
dans lequel la différence entre la capacité déterminée de l'élément de commutation dynamiquement reconfigurable (11) et la capacité maximale exigée des blocs fonctionnels (15 - 20, 30, 31, 32, 33, 34, 35, 36, 40, 40a) des états de fonctionnement forme une capacité libre (28),
dans lequel les blocs fonctionnels redondants (20 - 23, 30a, 30b, 31a, 31b, 32a, 32b, 33a) sont présentés par la capacité libre (28),
dans lequel les blocs fonctionnels redondants (20 - 23, 30a, 30b, 31a, 31b, 32a, 32b, 33a) sont dynamiquement reconfigurés,
dans lequel les blocs fonctionnels (15 - 19, 30, 31, 32, 33, 33a, 34, 35, 36, 40, 40a) des états de fonctionnement de l'appareil radio aérien (1) sont évalués en fonction d'applications déterminées selon leur importance pour la sécurité du système,
dans lequel les blocs fonctionnels redondants (15 - 19, 30, 31, 32, 33, 33a, 34, 35, 36, 40, 40a) sont présentés en redondance par la capacité libre (28) en fonction de leur importance pour les applications déterminées.

8. Procédé selon la revendication 7,
**caractérisé**
**en ce que** les blocs fonctionnels (17, 30₁, 31₁, 32) d'importance maximale sont présentés en redondance deux fois par la capacité libre (28),
**en ce que** les blocs fonctionnels (16, 18, 30₂, 31₂, 33₁) d'importance élevée sont présentés en redondance une fois par la capacité libre (28), et
**en ce que** les blocs fonctionnels (19, 33₂, 34, 35, 36, 40, 40a) de faible importance ne sont pas présentés en redondance par la capacité libre (28).

9. Procédé selon la revendication 7 ou 8,
**caractérisé**
**en ce que** les blocs fonctionnels redondants (20 - 23, 30a, 30b, 31a, 31b, 32a, 32b, 33a) sont présentés par pratiquement toute la capacité libre (28).

10. Procédé selon l'une des revendications 7 à 9,
**caractérisé**
**en ce que** les erreurs des blocs fonctionnels (15 -19, 30, 31, 32, 33, 34, 35, 36, 40, 40a) réalisés par l'élément de commutation dynamiquement reconfigurable (11) sont détectées, et
**en ce que** les blocs fonctionnels (40) défectueux sont dynamiquement reconfigurés par l'élément de commutation dynamiquement reconfigurable (11) sans interruption de fonctionnement de l'appareil radio aérien (1).

11. Procédé selon l'une des revendications 7 à 10,
**caractérisé**
**en ce que** l'apparition d'erreurs dans différentes zones de l'élément de commutation dynamiquement reconfigurable (11) est enregistrée,
**en ce que** l'accès à des zones déterminées de l'élément de commutation dynamiquement reconfigurable (11) est verrouillé en cas de dépassement d'une fréquence définie d'apparition d'erreurs dans lesdites zones, et
**en ce que** les blocs fonctionnels (40) réalisés par des zones à accès verrouillé sont reconfigurés dans des zones à accès non verrouillé.
